# DEMANDE DE BREVET EUROPEEN

(11) **EP 4 709 099 A1**
(43) Date de publication de la demande: **11.03.2026**
(21) Numéro de dépôt: 25199747.4
(22) Date de dépôt: 02.09.2025
(51) Int. Cl.: H10F 39/00

(54) **CAPTEUR D'UNE IMAGE EN PROFONDEUR COMPRENANT UN MOYEN DE REMISE À ZÉRO DE LA RÉGION PHOTOSENSIBLE**

(30) Priorité: 05.09.2024 FR 2409422
(71) Demandeur: Commissariat à l'Energie Atomique et aux Energies Alternatives, 75015 Paris (FR)
(72) Inventeur: SAXOD, Olivier, 38054 GRENOBLE CEDEX 09 (FR); PALMIGIANI, Gaëlle, 38054 GRENOBLE CEDEX 09 (FR)
(74) Mandataire: Santarelli

(57) **Abrégé**

L'invention porte sur un capteur d'une image en profondeur. Chaque pixel du capteur comporte des premiers et deuxièmes nœuds de détection et une zone de collecte situés à l'aplomb d'une région photosensible formée dans un substrat ; des premier et deuxième transistors de transfert comprenant respectivement des première et deuxième grilles verticales et des premier et deuxième canaux ; un transistor d'initialisation de la région photosensible à grilles multiples, comprenant un canal de collecte commandable par les première et deuxième grilles verticales. Les canaux des transistors s'étendent entre d'un côté la région photosensible et de l'autre les nœuds de détection et la zone de collecte. Le circuit de lecture est configuré pour appliquer respectivement des premier et deuxième signaux électriques aux première et deuxième grilles verticales de sorte à rendre alternativement passant chacun du premier canal, du deuxième canal et du canal de collecte, indépendamment des deux autres canaux.

## Description

### DOMAINE TECHNIQUE

Le domaine de l'invention est celui des capteurs d'image en profondeur fonctionnant sur un principe de mesure indirecte de temps de vol.

### ÉTAT DE LA TECHNIQUE ANTÉRIEURE

Les capteurs d'image en profondeur permettent d'obtenir une image en relief d'une scène. Parmi ceux-ci, il existe les capteurs d'image en profondeur fonctionnant sur un principe de mesure indirecte de temps de vol, appelés généralement « capteurs d'image iToF » (iToF pour « Indirect Time of Flight », en anglais). Un tel capteur d'image en profondeur comprend généralement une matrice de pixels de profondeur. Il est associé à une source lumineuse, par exemple un laser, pour éclairer la scène. La source lumineuse émet un signal lumineux périodique en amplitude, souvent sinusoïdal. Un pixel, ou un groupe de pixels contigus correspondant à un point de l'image, échantillonne le signal périodique reçu après réflexion sur la scène. Le capteur comprend des moyens de traitement permettant de déterminer un déphasage entre les signaux périodiques émis et reçus, et de convertir le déphasage en une distance séparant le capteur d'image du point de la scène conjugué avec le point de l'image.

Il est communément admis qu'au moins trois échantillons sur une période du signal périodique sont nécessaires pour effectuer une mesure de distance. Il est préférable d'utiliser quatre échantillons. Un échantillon est une intégration du signal périodique reçu par un pixel pendant une ou plusieurs périodes de temps, chacune égale à une fraction de la période du signal périodique, les périodes de temps étant espacées d'une période du signal périodique. De préférence, la fraction de la période du signal périodique est la même pour tous les échantillons, par exemple égale à l'inverse du nombre d'échantillons. Généralement, les périodes de temps d'intégration d'échantillons distincts ne se recouvrent pas.

Un pixel de profondeur comprend une région photosensible configurée pour convertir les photons du signal lumineux reçu en charges électriques, un premier transistor de transfert et un noeud de détection. La grille de transfert permet de transférer les charges électriques depuis la région photosensible vers le noeud de détection pendant les périodes de temps correspondant à un échantillon. Un nœud de détection est une région du pixel de profondeur à l'intérieur de laquelle des charges photo-générées sont collectées avant d'être lues par un circuit de lecture.

Le pixel de profondeur comporte généralement en outre, une région aveugle dédiée à une remise à zéro de la région photosensible avant chaque phase d'échantillonnage. On y trouve un transistor d'initialisation et une zone de collecte. Le transistor d'initialisation permet une évacuation des charges électriques de la région photosensible vers la zone de collecte au travers de son canal. Le document US10162048 propose un capteur d'images iTOF comprenant un transistor d'initialisation par pixel. Le document FR3065320 propose une solution plus compacte puisque le transistor d'initialisation a une grille verticale. Il apparaît cependant nécessaire de davantage réduire le volume occupé par la région dédiée à la remise à zéro de la région photosensible.

Le document US11581345 propose une solution alternative au transistor d'initialisation, particulièrement attractive pour sa compacité. Chaque pixel comporte une électrode verticale isolée de la région photosensible par une couche diélectrique comprenant des pièges de charges à son interface avec la région photosensible. Au moment de l'initialisation de la région photosensible, l'électrode verticale est polarisée par un train d'impulsions de durée comprise entre 10 ns et 2 ms pour générer une alternance de régimes d'inversion et d'accumulation dans la région photosensible, de sorte que des charges photo-générées dans la région photosensible se recombinent dans les pièges de charges.

Il apparaît cependant que la remise à zéro de la région photosensible est moins efficace avec cette solution qu'avec un transistor d'initialisation. De plus, il serait intéressant de supprimer les interconnexions spécifiquement dédiées à l'initialisation de la région photosensible.

### EXPOSÉ DE L'INVENTION

L'invention a pour objectif de remédier au moins en partie aux inconvénients de l'art antérieur, et plus particulièrement de proposer un capteur d'une image en profondeur comprenant une pluralité de pixels, chacun comprenant une région photosensible et un moyen d'initialisation de la région photosensible plus compact que ceux des dispositifs de l'art antérieur.

Pour cela, l'objet de l'invention est un capteur d'une image en profondeur comprenant un circuit de lecture et une pluralité de pixels formés dans et sur un substrat du capteur. Chaque pixel comporte une région photosensible formée dans le substrat et configurée pour convertir des photons en charges électriques ; un premier nœud de détection, un deuxième nœud de détection et une zone de collecte situés à l'aplomb de la région photosensible et dopés d'un premier type de conductivité ; un premier transistor de transfert comprenant une première grille verticale et un premier canal commandable par la première grille verticale ; un deuxième transistor de transfert comprenant une deuxième grille verticale et un deuxième canal commandable par la deuxième grille verticale ; un transistor d'initialisation de la région photosensible à grilles multiples, comprenant les première et deuxième grilles verticales et un canal de collecte commandable par les première et deuxième grilles verticales. Chaque pixel est tel que le premier canal, le deuxième canal et le canal de collecte s'étendent dans le substrat entre la région photosensible et, respectivement, le premier nœud de détection, le deuxième nœud de détection et la zone de collecte. Le circuit de lecture est configuré pour appliquer un premier signal électrique à la première grille verticale et un deuxième signal électrique à la deuxième grille verticale de sorte à rendre alternativement passant chacun du premier canal, du deuxième canal et du canal de collecte, indépendamment des deux autres canaux.

Certains aspects préférés mais non limitatifs de ce capteur sont les suivants.

La zone de collecte peut s'étendre verticalement dans le substrat plus profondément que les premier et deuxièmes nœuds de détection.

Chaque pixel peut comprendre en outre une tranchée d'isolation périphérique pouvant s'étendre verticalement dans le substrat depuis une face supérieure du substrat et pouvant délimiter latéralement la région photosensible.

Le capteur peut comprendre en outre un caisson dopé d'un deuxième type de conductivité opposé au premier type de conductivité. Le caisson peut être en contact avec la tranchée d'isolation périphérique et peut affleurer la face supérieure du substrat.

La tranchée d'isolation périphérique peut comprendre une électrode verticale en un matériau semiconducteur dopé du deuxième type de conductivité.

Les première et deuxième grilles verticales peuvent comporter des portions principales respectives en vis-à-vis, symétriques l'une de l'autre par rapport à un axe de symétrie vertical passant par le centre du pixel et dans lequel la zone de collecte peut s'étendre d'une portion principale à l'autre.

Les première et deuxième grilles verticales peuvent avoir chacune une forme de U en vue de dessus. Le premier nœud de détection et le deuxième nœud de détection peuvent s'étendre chacun entre deux branches opposées du U formé par, respectivement, la première grille verticale et la deuxième grille verticale.

Le circuit de lecture peut comporter un contact d'initialisation. Le pixel peut comprendre en outre une zone de contact périphérique du premier type de conductivité, pouvant prolonger la zone de collecte dans une région périphérique du pixel sur laquelle repose le contact d'initialisation.

Le circuit de lecture peut être configuré pour commuter en opposition de phase, le premier signal électrique et le deuxième signal électrique entre une première valeur et une deuxième valeur de manière à rendre alternativement passant le premier canal et le deuxième canal lors d'une phase d'échantillonnage, tout en maintenant bloqué le canal de collecte.

Le circuit de lecture peut être configuré pour affecter une troisième valeur au premier signal électrique et au deuxième signal électrique de manière à rendre passant le canal de collecte pendant une phase d'initialisation de la région photosensible précédant la phase d'échantillonnage.

La pluralité de pixels peut être agencée en matrice. Le circuit de lecture peut être configuré pour affecter un potentiel électrique égal à une valeur intermédiaire aux première et deuxième grilles verticales de manière à empêcher un transfert de charges électriques photo-générées dans la région photosensible vers les premier et deuxième nœuds de détection pendant une phase de lecture de la matrice, la valeur intermédiaire pouvant être différente de la troisième valeur.

### BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :
la figure 1A est une vue schématique de dessus d'un premier mode de réalisation d'un capteur d'une image en profondeur ;
la figure 1B est un exemple de cartographie d'atomes dopants vue dans le plan de coupe A-A de la figure 1A ;
la figure 1C est une vue schématique du premier mode de réalisation selon la coupe A-A de la figure 1A ;
la figure 2A est une vue schématique de dessus d'une variante du premier mode de réalisation d'un capteur d'une image en profondeur ;
la figure 2B est un exemple de cartographie d'atomes dopants vue dans le plan de coupe A-A de la figure 2A ;
la figure 2C est l'exemple de cartographie d'atomes dopants vue dans le plan de coupe B-B de la figure 2A ;
la figure 3A est un schéma électrique représentatif du premier mode de réalisation et de sa variante ;
la figure 3B est un exemple de chronogramme mis en œuvre par le premier mode de réalisation ou sa variante, lorsqu'ils sont en fonctionnement ;
la figure 4A est un exemple de cartographie du potentiel électrique dans des plans de coupes du premier mode de réalisation et de sa variante, pour un état de polarisation particulier ;
la figure 4B est un exemple de cartographie du potentiel électrique dans des plans de coupes du premier mode de réalisation et de sa variante, lors d'une phase d'échantillonnage ;
la figure 4C est un exemple de cartographie du potentiel électrique dans des plans de coupes du premier mode de réalisation et de sa variante, lors d'une phase de lecture de la pluralité de pixels ou lors d'une phase d'initialisation ;
les figures 5A et 5B sont des courbes donnant la valeur du potentiel électrique de la figure 4C, le long de segments horizontaux particuliers ;
les figures 6A, 6B, 6C, 6D, 6E, 6F et 6G sont des vues schématiques de dessus d'autres modes de réalisation selon l'invention.

### EXPOSÉ DÉTAILLÉ DE MODES DE RÉALISATION PARTICULIERS

Sur les figures et dans la suite de la description, les mêmes références représentent les éléments identiques ou similaires. De plus, les différents éléments ne sont pas représentés à l'échelle de manière à privilégier la clarté des figures. Par ailleurs, les différents modes de réalisation et variantes ne sont pas exclusifs les uns des autres et peuvent être combinés entre eux. Sauf indication contraire, les termes « sensiblement », « environ », « de l'ordre de » signifient à 10% près, et de préférence à 5% près. Par ailleurs, les termes « compris entre ... et ... » et équivalents signifient que les bornes sont incluses, sauf mention contraire.

L'invention porte sur un capteur d'une image en profondeur comprenant un circuit de lecture et une pluralité de pixels formés dans et sur un substrat du capteur d'image. Chaque pixel comporte une région photosensible, un moyen pour initialiser la région photosensible, au moins deux nœuds de détection et une grille de transfert pour chaque nœud de détection apte à transférer des charges électriques photo-générées dans la région photosensible vers un nœud de détection correspondant.

Dans le capteur de l'invention, le moyen pour initialiser la région photosensible est un transistor d'initialisation à multiple grilles, dont les grilles sont les grilles de transfert. L'application d'un potentiel électrique non nul à toutes les grilles de transfert rend prioritaire le transfert des charges électriques depuis la région photosensible vers un drain du transistor d'initialisation, appelé ci-après zone de collecte. La zone de collecte est une région du pixel distincte des nœuds de détection. Ainsi, il est possible d'initialiser la région photosensible du pixel sans grilles ou interconnexions supplémentaires, en plus de celles nécessaires à la lecture des échantillons.

Dans la description, un transfert de charges selon un canal, ou d'une région à une autre, est dit prioritaire, si au moins 90 % des charges électriques transférées le sont par ce canal, ou de la région à l'autre. Le cas échéant, la proportion est préférentiellement supérieure ou égale à 95 %, voire supérieur ou égal à 97 %, ou encore supérieur ou égal à 99 %.

Lorsqu'un premier canal d'un transistor est passant indépendamment d'un autre canal ou d'autres canaux de transistors, le transfert de charges par le premier canal est prioritaire.

Des modes de réalisation particuliers vont être décrits se rapportant à un capteur d'une image de profondeur configuré pour une lecture en tension. Cependant, ces modes de réalisation peuvent être adaptés à d'autres dispositifs optoélectroniques.

Chaque mode de réalisation décrit ci-après adopte une combinaison particulière de conductivités associées aux zones dopées, étant entendu que la combinaison peut être inversée sans sortir du cadre de l'invention. Ainsi, pour un mode de réalisation particulier toutes les zones dopées P peuvent être dopées N et toutes les zones dopées N peuvent être dopées P, à condition de changer le type de conductivité de toutes les zones dopées.

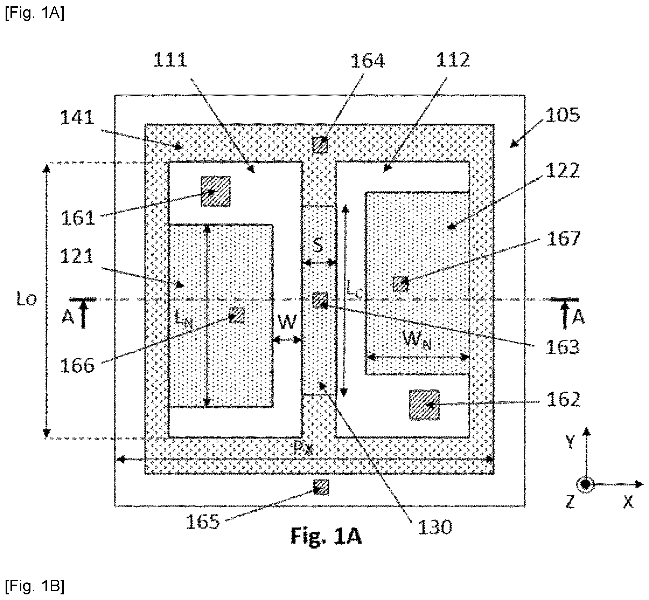

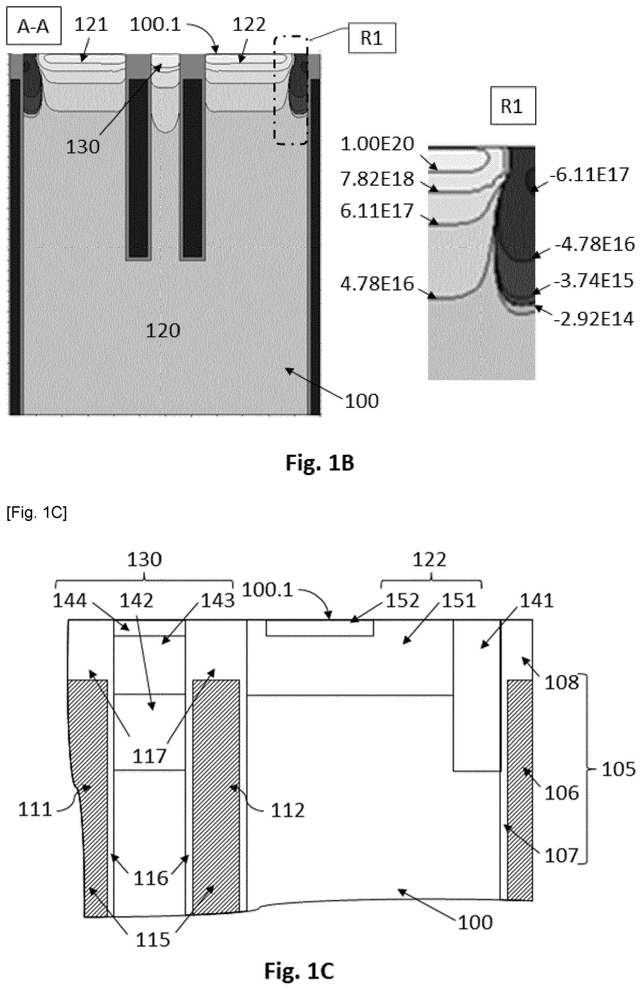

Un premier mode de réalisation d'un capteur d'image selon l'invention va à présent être décrit en lien avec les figures 1A, 1B et 1C. Les figures 1A et 1C sont des vues schématiques respectivement, de dessus et en coupe. Le plan de coupe de la figure 1C est représenté par une ligne mixte sur la figure 1A. La figure 1B représente une cartographie **de la concentration** en éléments dopants dans le plan de coupe de la figure 1C, obtenue par simulation.

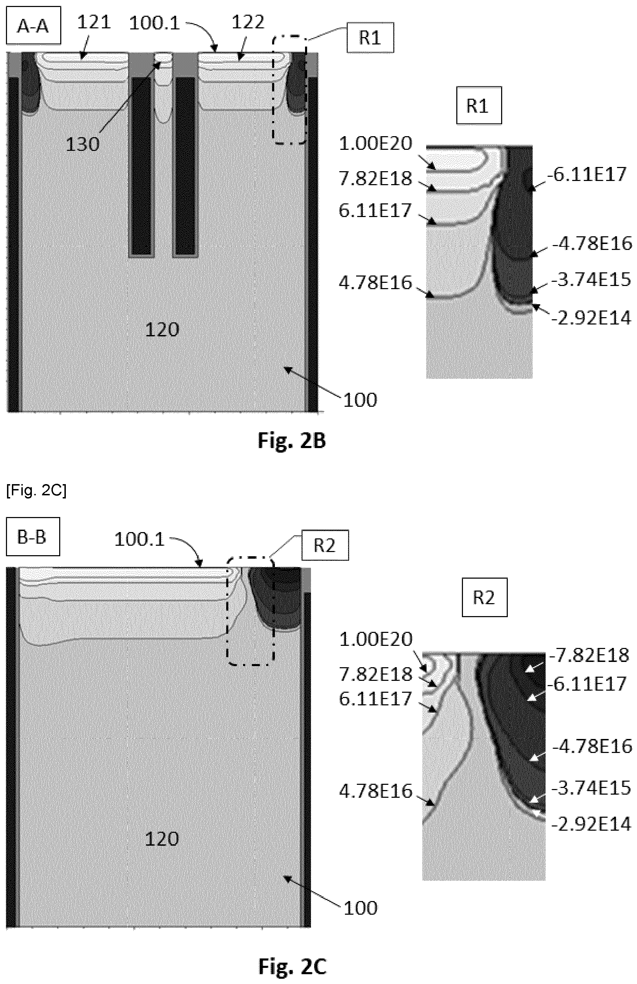

Les cartographies en niveaux de gris des figures 1B, 2B, 2C, 4A, 4B et 4C sont des résultats de simulation obtenus par un logiciel pour la conception de technologie assistée par ordinateur (ou TCAD, pour « Technology Computer-Aided Design », en anglais). A droite des figures 1B, 2B et 2C, on a donné les valeurs numériques de concentrations en atomes dopants par cm³ correspondant à des lignes de niveau apparaissant à l'intérieur de régions repérées par des encadrés en lignes mixtes, sur la partie de gauche de ces figures. Une valeur négative correspond à un dopage de type P, une valeur positive, à un dopage de type N. Bien qu'un niveau de gris soit affecté aux parties diélectriques du pixel, il n'est pas représentatif d'une concentration d'atomes dopants.

Le premier mode de réalisation comprend un circuit de lecture et une pluralité de pixels formés dans et sur un substrat 100. Sur les figures 1A à 1C, seul un pixel a été représenté. Pour ne pas surcharger les schémas, certains éléments ont été omis, comme par exemple les lignes d'interconnexion. Pour en améliorer la lisibilité, seule une partie supérieure du substrat 100 est représentée sur les vues en coupe. Sur les vues schématiques, les éléments sont représentés par des formes géométriques simples. Ceux-ci sont reproduits sur le dispositif réalisé à des erreurs de fabrication près, comme par exemple des erreurs d'alignement, de dimensionnel ou des arrondis de coins induits par un manque de résolution.

Le substrat 100 comporte une face supérieure 100.1 et une face inférieure opposée à la face supérieure 100.1. Les faces inférieure et supérieure 100.1 sont sensiblement planes et parallèles entre elles. Le pixel comprend une région photosensible 120, un premier noeud de détection 121, un deuxième noeud de détection 122, une zone de collecte 130, un caisson P 141, une première grille verticale 111 et une deuxième grille verticale 112. Les premier et deuxième noeuds de détection 121, 122, les première et deuxième grilles verticales 111, 112, la zone de collecte 130 et le caisson P 141 affleurent la face supérieure 100.1.

On définit ici et pour la suite de la description un repère direct tridimensionnel orthogonal (X, Y, Z), où les axes X et Y forment un plan parallèle à la face supérieure 100.1 du substrat 100, l'axe X étant orienté parallèlement au plan de coupe A-A, et où l'axe Z est orienté de manière sensiblement orthogonale à la face supérieure 100.1 du substrat 100, depuis la face inférieure vers la face supérieure 100.1. Dans la suite de la description, les termes « vertical » et « verticalement » s'entendent comme étant relatifs à une orientation sensiblement parallèle à l'axe Z, et les termes « horizontal » et « horizontalement » comme étant relatifs à une orientation sensiblement parallèle au plan (X, Y). Par ailleurs, les termes « inférieur » et « supérieur » s'entendent comme étant relatifs à un positionnement croissant lorsqu'on se déplace suivant la direction +Z. Le terme « latéral » se réfère à une orientation sensiblement parallèle à l'axe Z. Une vue de dessus est une vue selon la direction -Z.

Comme cela est connu en soi dans le domaine technique, une grille verticale comprend une électrode de grille s'étendant verticalement dans le substrat sur une profondeur strictement supérieure à ses dimensions horizontales. A titre d'exemple, cette profondeur peut âtre au moins 2 fois supérieure, 5 fois, voire 10 fois supérieure à l'une de ses dimensions horizontales. Une telle grille verticale comprend en outre un oxyde de grille revêtant l'électrode de grille de sorte à l'isoler électriquement du substrat. Une grille verticale commande un canal s'étendant en profondeur dans le substrat le long de l'oxyde de grille.

Le substrat 100 est en un matériau semiconducteur. Il est ici en silicium cristallin. Il s'agit par exemple d'une plaque en silicium ou d'une partie d'une plaque en silicium. Il peut comprendre une ou plusieurs couches épitaxiées en silicium cristallin, ainsi qu'une ou plusieurs couches de passivation.

Dans cet exemple, le pixel comprend une tranchée d'isolation périphérique 105 s'étendant verticalement dans le substrat 100 depuis la face supérieure 100.1. De préférence, la tranchée d'isolation périphérique 105 traverse de part en part le substrat 100. Ici, la tranchée d'isolation périphérique 105 est une tranchée d'isolation capacitive. Elle délimite la région photosensible 120 dans un plan horizontal. **En** vue de dessus, elle entoure de toutes parts la région photosensible 120 et présente un contour fermé, ici de forme sensiblement carrée, de côtés parallèles à l'axe X ou à l'axe Y. Dans le plan de la face supérieure 100.1, la distance Px séparant un bord externe d'un côté du carré à un bord interne du côté opposé du carré définit une taille du pixel. Dans cet exemple, la taille Px du pixel est égale à 1,2 µm. Elle peut être inférieure ou égale à 1,2 µm, voire inférieure ou égale à 1 µm.

La tranchée d'isolation périphérique 105 comporte une paroi interne transversale, située du côté du centre du pixel. Elle comporte une électrode verticale 106 en un matériau conducteur de l'électricité. L'électrode verticale 106 peut être en un métal, en un alliage métallique ou en un matériau semiconducteur dopé. Elle est ici en silicium polycristallin dopé de type P. Elle s'étend verticalement en regard de la région photosensible 120, de préférence en regard de toute la région photosensible 120.

La tranchée d'isolation périphérique 105 comporte en outre une couche diélectrique intercalaire 107 revêtant l'électrode verticale 106, sur toute la paroi interne de la tranchée d'isolation périphérique 105. La couche diélectrique intercalaire 107 est en tout matériau diélectrique. Elle est ici en oxyde de silicium.

La tranchée d'isolation périphérique 105 a par exemple une largeur horizontale comprise entre 20 nm et 300 nm, ici égale à 100 nm. Elle a une hauteur verticale comprise entre 1 µm et 20 µm, de préférence égale à l'épaisseur du substrat 100.

Dans cet exemple, la tranchée d'isolation périphérique 105 comporte du côté de la face supérieure 100.1 du substrat 100, une région isolante 108 optionnelle reposant sur une extrémité supérieure de l'électrode verticale 106, de manière à être en contact physique avec celle-ci. La région isolante 108 est en un matériau isolant électrique. Elle peut être en un matériau diélectrique identique à la couche diélectrique intercalaire 107. Elle est ici en oxyde de silicium.

Lorsque la pluralité de pixels est agencée en une matrice selon des rangées et des colonnes, les rangées et les colonnes s'étendent de préférence, respectivement, selon les axes X et Y. Le cas échéant deux pixels voisin de la matrice peuvent partager une partie de leurs tranchées d'isolation périphérique 105. Ainsi, les tranchées d'isolation périphérique 105 de tous les pixels peuvent constituer ensemble un maillage orthogonal en vue de dessus, par exemple de mailles carrées de côtés parallèles aux axes X et Y.

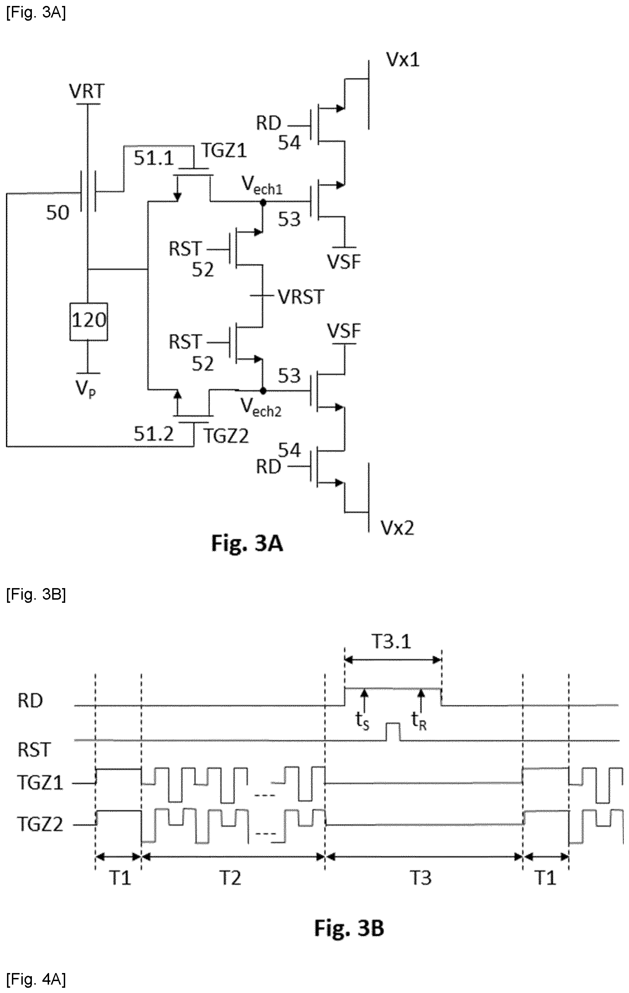

Le pixel comporte en outre un premier transistor de transfert 51.1 et un deuxième transistor de transfert 51.2 (repérés sur le schéma électrique de la figure 3A). Le premier transistor de transfert 51.1 comprend la première grille verticale 111 et un premier canal commandable par la première grille verticale 111. De façon similaire, le deuxième transistor de transfert 51.2 comprend la deuxième grille verticale 112 et un deuxième canal commandable par la deuxième grille verticale 112. Les premier et deuxième noeuds de détection 121, 122 constituent respectivement, un drain du premier transistor de transfert 51.1 et du deuxième transistor de transfert 51.2.

Dans cet exemple, de sorte à simplifier la conception du pixel, les première et deuxième grilles verticales 111, 112 sont identiques, sans que cela soit une caractéristique essentielle de l'invention. Elles sont ici agencées dans le pixel de façon à être symétrique l'une de l'autre par rapport à un axe de symétrie parallèle à l'axe Z et perpendiculaire à la face supérieure 100.1 du substrat 100. Ici, l'axe de symétrie passe par le centre du pixel. Ainsi, seule la première grille verticale 111 est décrite en détail ci-après.

La première grille verticale 111 s'étend verticalement dans le substrat 100, en partie en regard du premier canal, depuis la face supérieure 100.1, jusqu'à une profondeur strictement inférieure à la hauteur de la tranchée d'isolation périphérique 105. De manière similaire, la deuxième grille verticale 112 s'étend verticalement dans le substrat 100, en partie en regard du deuxième canal, depuis la face supérieure 100.1, sur une profondeur égale à la profondeur de la première grille verticale 111.

La première grille verticale 111 présente en vue de dessus une forme en U. Elle comporte une portion principale formant la base du U, s'étendant parallèlement au plan (Y, Z), ainsi qu'une première branche et une deuxième branche du U s'étendant parallèlement au plan (X, Z). Dans cet exemple, la portion principale et la première branche ont des largeurs horizontales sensiblement égales à une valeur W. La deuxième branche a ici une largeur horizontale strictement supérieure à W. La largeur horizontale de la deuxième branche est par exemple suffisante pour garantir qu'un premier contact de grille 161 du circuit de lecture repose entièrement sur la deuxième branche malgré des incertitudes de fabrication.

La première grille verticale 111 comporte une électrode de grille 115, une couche isolante 116 et une région isolante 117 optionnelle. Elle a une structure analogue à la tranchée d'isolation périphérique 105. L'électrode de grille 115 est en un matériau conducteur de l'électricité, par exemple en métal, en alliage métallique ou en un semiconducteur dopé. Elle peut être en un matériau identique à celui de l'électrode verticale 106. Elle est ici en silicium polycristallin dopé de type P.

La couche isolante 116 revêt entièrement toutes les faces latérales et la face inférieure de l'électrode de grille 115. Elle est en un matériau isolant électrique, par exemple en tout type de matériau diélectrique. Elle est ici en oxyde de silicium.

La région isolante 117 repose sur une extrémité supérieure de l'électrode de grille 115, de manière à être en contact physique avec celle-ci. Elle est en un matériau isolant électrique, avantageusement du même matériau que la région isolante 108. Elle peut être en un matériau diélectrique identique à la couche isolante 116. Elle est ici en oxyde de silicium. Lorsque les régions isolantes 108 et 117 sont du même matériau et s'étendent depuis la face supérieure 100.1 sur une même profondeur, comme représenté ici, elles peuvent être réalisées simultanément.

Les première et deuxième grilles verticales 111, 112 ont par exemple une largeur horizontale W comprise entre 20 nm et 300 nm, ici égale à 100 nm. Elles ont une hauteur verticale comprise entre 0,2 µm et 1,5 µm. Ici, la deuxième branche a une largeur horizontale égale à 200 nm. Les régions isolantes 108 et 117 ont une hauteur verticale inférieure à 600 nm, ici égales à 100 nm.

Les portions principales des première et deuxième grilles verticales 111, 112 sont en vis-à-vis dans le plan de la face supérieure 100.1, de préférence, comme c'est le cas ici, les portions principales sont parallèles entre-elles. Ici, en vue de dessus, elles sont sensiblement rectilignes et en regard l'une de l'autre sur toute leur longueur.

Dans cet exemple, de sorte à simplifier la conception du pixel, les premier et deuxième nœuds de détection 121, 122 sont symétriques l'un de l'autre par rapport à l'axe de symétrie, sans que cela soit une caractéristique essentielle de l'invention. Ainsi seul le deuxième nœud de détection 122 est décrit en détail ci-après, en lien avec les figures 1A et 1C. Les éléments constitutifs du premier nœud de détection 121 se déduisent par la symétrie axiale d'éléments symétriques constitutifs du deuxième nœud de détection 122. Une caractéristique ou un paramètre défini pour le deuxième nœud de détection 122 relativement à la deuxième grille verticale 112 est transposé au premier nœud de détection 121 relativement à la première grille verticale 111 par application de la symétrie axiale.

Le deuxième nœud de détection 122 comporte une région dopée N 151 et une région surdopée N 152 optionnelle. La région surdopée N 152 comporte une concentration en éléments dopants de type donneur strictement supérieure à une concentration en éléments dopants de type donneur de la région dopée N 151. De préférence, la région surdopée N 152 permet la réalisation d'un contact ohmique entre le deuxième nœud de détection 122 et le circuit de lecture.

La région dopée N 151 est intercalée entre la tranchée d'isolation périphérique 105 et la deuxième grille verticale 112. Elle s'étend verticalement dans le substrat 100 depuis la face supérieure 100.1, jusqu'à une profondeur supérieure à la hauteur de la région isolante 117. Dans cet exemple, elle est délimitée latéralement par la deuxième grille verticale 112, de façon à être entourée par la deuxième grille verticale 112 sur trois de ses côtés en vue de dessus. La région dopée N 151 s'étend horizontalement sur une longueur L_{N}, depuis la première branche jusqu'à la deuxième branche de la deuxième grille verticale 112. Elle s'étend en vue de dessus sur une largeur W_{N}, jusqu'à la portion principale de la deuxième grille verticale 112. Dans cet exemple, les première et deuxième branches des première et deuxième grilles verticales 111, 112 sont d'égales longueurs. La région dopée N 151 a une largeur Wn, mesurée parallèlement à l'axe X, sensiblement égale à la longueur mesurée parallèlement à l'axe X des première et deuxième branches de la deuxième grille verticale 112.

Chaque région surdopée N 152 est formée à l'intérieur d'une région dopée N 151. Elle s'étend depuis la face supérieure 100.1 sur une profondeur inférieure à la région dopée N 151. Elle a ici toutes ses dimensions horizontales strictement inférieures à des dimensions horizontales correspondantes de la région dopée N 151.

Dans cet exemple, la région dopée N 151 a une concentration en éléments dopants de type donneur comprise entre 1E16 at/cm³ et 5E20 at/cm³. La région surdopée N 152 a une concentration en éléments dopants de type donneur comprise entre 1E17 at/cm³ et 5E20 at/cm³. La région dopée N 151 a une hauteur mesurée le long de l'axe Z qui excède la hauteur de la région isolante 117 de 0 nm à 400 nm. La région surdopée N 152 a une hauteur mesurée le long de l'axe Z comprise entre 10 nm et 200 nm. La largeur Wn est comprise entre 10 % et 40 % de la taille du pixel Pₓ, ici égale à 326 nm.

Le caisson P 141 est dopé avec des éléments dopants de type accepteur. En vue de dessus, le caisson P 141 entoure de préférence les première et deuxième grilles verticales 111, 112, les premier et deuxième noeuds de détection 121, 122. Ici, il entoure également la zone de collecte 130. Dans ce mode de réalisation, il a un contour fermé épousant la tranchée d'isolation périphérique 105, en vue de dessus. Il s'étend verticalement dans le substrat 100 depuis la face supérieure 100.1, sur une profondeur supérieure à la hauteur de la région isolante 108 de la tranchée d'isolation périphérique 105. Il s'étend ici selon l'axe Z sur une profondeur supérieure à la hauteur de la région dopée N 151, c'est-à-dire sur une profondeur supérieure aux hauteurs des premier et deuxième noeuds de détection 121, 122.

Le caisson P 141 est en contact avec la paroi interne de la tranchée d'isolation périphérique 105, formant ainsi une réserve de trous dérivant le long de la paroi interne de la tranchée d'isolation périphérique 105, notamment lorsque la tranchée d'isolation périphérique 105 est polarisée en forte inversion. Pour ce pixel particulier, un potentiel négatif est appliqué à l'électrode verticale 106 lorsque le capteur est en fonctionnement, de sorte à attirer des trous du caisson P 141 le long de la paroi interne. Les trous participent à la passivation de l'interface du substrat 100 avec la paroi interne, et à la formation d'une barrière de potentiel. De préférence, comme représenté ici, le caisson P 141 est en contact avec la paroi interne de la tranchée d'isolation périphérique 105 sur sensiblement tout son pourtour, en vue de dessus.

Le caisson P 141 a par exemple une concentration en éléments dopants de type accepteur comprise entre 1E16 at/cm³ et 1E19 at/cm³. Il a une hauteur mesurée parallèlement à l'axe Z qui excède la hauteur de la région isolante 108 de 0 nm à 400 nm.

La zone de collecte 130 comporte une région dopée N 143. Elle comprend, comme représenté ici, une région surdopée N 144 optionnelle et un caisson N 142 optionnel. La région dopée N 143 s'étend horizontalement depuis la portion principale de la première grille verticale 111 jusqu'à la portion principale de deuxième grille verticale 112. La zone de collecte 130 s'étend verticalement dans le substrat 100 depuis la face supérieure 100.1 sur une profondeur supérieure à la hauteur des régions isolantes 117 des première et deuxième grilles verticales 111, 112. La région surdopée N 144 est formée à l'intérieur de la région dopée N 143. Elle a une concentration en éléments dopant de type donneur supérieure à une concentration en éléments dopants de type donneur de la région dopée N 143. De préférence, la région surdopée N 144 permet la réalisation d'un contact ohmique entre la zone de collecte 130 et le circuit de lecture.

Le caisson N 142 s'étend horizontalement depuis la portion principale de la première grille verticale 111 jusqu'à la portion principale de la deuxième grille verticale 112. Il s'étend verticalement dans le substrat 100 plus profondément que la région surdopée N 144 et la région dopée N 143. En vue de dessus, la région dopée N 143 occupe par exemple une surface du pixel située à l'intérieur du caisson N 142. Ici, le caisson N 142 s'étend selon l'axe Y, entre les portions principales des première et deuxième grilles verticales 111, 112, sur une longueur strictement inférieure à une longueur de vis-à-vis, le long de laquelle les première et deuxième grilles verticales 111, 112 sont en regard en vue de dessus. Ainsi, la zone de collecte 130 s'étend selon l'axe Y sur une longueur L_{C} strictement inférieure à la longueur de vis-à-vis. Sur la figure 1A, elle est centrée sur le centre du pixel.

Avantageusement, la région dopée N 143 (respectivement la région surdopée N 144) de la zone de collecte 130 et les régions dopées N 151 (respectivement les régions surdopées N 152) des premier et deuxième noeuds de détection 121, 122 sont réalisées par les mêmes étapes de procédé, de sorte qu'elles ont des profondeurs sensiblement égales et des profils de dopage en Z sensiblement égaux. Une concentration en éléments dopant de type donneur du caisson N 142 et/ou sa profondeur sont choisies pour augmenter une proportion de charges électriques transférées par le canal de collecte et/ou le premier canal et/ou le deuxième canal lors d'une ou plusieurs phases de fonctionnement du capteur d'une image en profondeur. Dans ce mode de réalisation, le caisson N 142 s'étend verticalement dans le substrat 100 plus profondément que les premier et deuxième noeuds de détection 121, 122 pour favoriser le transfert de charges électriques depuis la région photosensible 120 vers la zone de collecte 130, lors d'une phase d'initialisation de la région photosensible 120 et/ou une phase de lecture d'échantillons collectés sur les premier et deuxième noeuds de détection 121, 122, lorsque le capteur est en fonctionnement.

La longueur L_{C} est par exemple supérieure ou égale à 100 nm. La longueur L_{N} peut être comprise entre 15 % et 60 % de la taille du pixel Pₓ, ici égale à 584 nm. La région dopée N 143 a une concentration en éléments dopants de type donneur comprise entre 1E16 at/cm³ et 5E20 at/cm³. La région surdopée N 144 a une concentration en éléments dopants de type donneur comprise entre 1E17 at/cm³ et 5E20 at/cm³. Le caisson N 142 a une concentration en éléments dopants de type donneur comprise entre 1E16 at/cm3 et 1E19 at/cm3.

La région photosensible 120 est une région du substrat 100 destinée à collecter des photons et à les convertir en charges électriques. Elle occupe une région du substrat 100 dopée de type N, présentant une concentration en espèces dopantes de type donneur comprise entre 1E12 at/cm³ et 1E18 at/cm³. Dans cet exemple, la région photosensible 120 est destinée à recevoir les photons depuis la face inférieure du substrat 100. La face inférieure peut être revêtue d'une couche de passivation, par exemple une couche en silicium dopée P.

Les premier et deuxième nœuds de détection 121, 122 et la zone de collecte 130 sont situées à l'aplomb de la région photosensible 120. Le premier canal (respectivement deuxième canal) est une région du substrat 100 occupée par des charges électriques photo-générées dans la région photosensible 120 lors de leur transit depuis la région photosensible 120 jusqu'au premier (respectivement deuxième) nœud de détection 121 (respectivement 122) lorsque le capteur est en fonctionnement. De façon analogue, le canal de collecte est une région du substrat 100 occupée par des charges électriques photo-générées dans la région photosensible 120 lors de leur transit depuis la région photosensible 120 jusqu'à la zone de collecte 130 lorsque le capteur est en fonctionnement.

Les premier et deuxième canaux, et le canal de collecte sont situés dans le substrat 100 entre la région photosensible 120 et, respectivement, le premier nœud de détection 121, le deuxième nœud de détection 122 et la zone de collecte 130. Le premier canal est situé au moins en partie entre la première branche, la deuxième branche et la portion principale de la première grille verticale 111. Le deuxième canal est situé au moins en partie entre la première branche, la deuxième branche et la portion principale de la deuxième grille verticale 112. Le canal de collecte est situé au moins en partie entre les portions principales des première et deuxième grilles verticales 111, 112.

La forme en U de la première (respectivement deuxième) grille verticale 111 (respectivement 112) permet d'améliorer le contrôle du premier (respectivement deuxième) canal. Elle permet notamment d'accroître la proportion de charges électriques transférées depuis la région photosensible 120 vers le premier nœud de détection 121 (respectivement deuxième nœud de détection 122) lorsque le premier canal (respectivement deuxième canal) est passant et le deuxième canal (respectivement premier canal) est bloqué.

En vue de dessus, les portions principales des première et deuxième grilles verticales 111, 112 sont espacées d'une distance S, au niveau de la zone de collecte 130 et du canal de collecte.

Le premier canal, le deuxième canal et le canal de collecte sont ici dopés du même type que les premier et deuxième nœuds de détection 121, 122 et du même type que la zone de collecte 130, c'est-à-dire de type N. Ils ont chacun une concentration en espèces dopantes qui est strictement inférieure à des concentrations minimales respectives des premier et deuxième nœuds de détection 121, 122 et de la zone de collecte 130. Ici, ils ont sensiblement la même concentration d'atomes dopants. Ils ont par exemple une concentration en atomes dopants comprise entre 1E12 at/cm³ et 1E18 at/cm³.

Le circuit de lecture est représenté schématiquement en figure 3A. Il comporte le premier contact de grille 161, un deuxième contact de grille 162, un contact d'initialisation 163, un contact P 164, un contact périphérique 165, un premier contact 166 et un deuxième contact 167, tels que représentés sur la figure 1A. Chacun de ces contacts est de préférence métallique.

Les premier et deuxième contacts de grilles 161, 162 permettent d'appliquer respectivement un premier signal électrique TGZ1 à la première grille verticale 111 et un deuxième signal électrique TGZ2 à la deuxième grille verticale 112. Ils sont en contact physique avec l'électrode de grille 115 de, respectivement, la première grille verticale 111 et la deuxième grille verticale 112. Ils traversent de part en part les régions isolantes 117 de chaque grille verticale 111, 112. Les signaux électriques TGZ1, TGZ2 sont des potentiels électriques variables dans le temps.

Le contact d'initialisation 163 permet d'appliquer un potentiel électrique VRT à la zone de collecte 130. Il est en contact physique avec la région surdopée N 144 de la zone de collecte 130. Il est, dans ce mode de réalisation, situé au centre du pixel, entre les portions principales des première et deuxième grilles verticales 111, 112. Pour un meilleur contrôle du canal de collecte, la distance S est de préférence choisie égale à une distance minimale autorisée par des règles de conception de la technologie utilisée pour réaliser le capteur. Les règles de conception prennent généralement en compte une distance minimale autorisée entre un contact électrique et une grille verticale, et une dimension minimale pour un contact électrique. A titre d'exemple, la distance S est comprise entre 10 nm et 300 nm, ici égale à 108 nm.

Les premier et deuxième contact 166, 167 sont en contact physique avec la région surdopée N 152 du, respectivement, premier nœud de détection 121 et du deuxième nœud de détection 122. En fonctionnement, leurs potentiels électriques sont respectivement égaux à des valeurs V_{ech1} et V_{ech2}.

Le contact P 164 permet d'appliquer un potentiel électrique V_{P} au caisson P 141. Il est en contact physique avec le caisson P 141 au niveau d'une région périphérique du pixel, maximisant de préférence une distance séparant le contact P 164 des première et deuxième grilles verticales 111, 112 et de la tranchée d'isolation périphérique 105. Il est ici situé dans le plan parallèle au plan (Y, Z) passant par le centre du pixel.

Le contact périphérique 165 permet d'appliquer un potentiel électrique V_{CDTI} à la tranchée d'isolation périphérique 105. Il est en contact physique avec l'électrode verticale 106 et traverse de part en part la région isolante 108 de la tranchée d'isolation périphérique 105.

La région photosensible 120 est reliée électriquement au premier nœud de détection 121 et au deuxième nœud de détection 122 par l'intermédiaire, respectivement, du premier transistor de transfert 51.1 et du deuxième transistor de transfert 51.2. Elle est reliée électriquement via le caisson P 141 et le contact P 164 à un nœud ou un rail de fourniture d'un potentiel électrique V_{P}.

Le circuit de lecture comporte des blocs de lecture d'un échantillon. Dans cet exemple, le nombre de blocs de lecture est égal au nombre d'échantillons collectés par le pixel. Ils sont ici identiques et au nombre de deux. Chacun d'eux est connecté électriquement à un nœud de détection 121, 122 et à un rail de sortie Vx1, Vx2 du circuit de lecture. Chaque bloc de lecture comporte un transistor de précharge 52, un transistor 53 monté en source suiveuse et un transistor de sélection 54.

Les drains des premier et deuxième transistors de transfert 51.1, 51.2 sont respectivement connectés électriquement à la grille du transistor 53 et à la source du transistor de précharge 52 d'un bloc de lecture distinct. La source du transistor 53 est connectée au drain du transistor de sélection 54. Le drain du transistor 53 est connecté à un nœud ou un rail de fourniture d'un potentiel électrique VSF. Le drain du transistor de précharge 52 est connecté à un nœud ou un rail de fourniture d'un potentiel électrique V_{RST}. La source du transistor de sélection 54 est connectée au rail de sortie Vx1, si le bloc de lecture est connecté au premier nœud de détection 121, au rail de sortie Vx2, dans le cas contraire. Les transistors de précharge 52 permettent d'initialiser les premier et deuxième nœuds de détection 121, 122 a un potentiel électrique sensiblement égal à V_{RST}.

Le contact d'initialisation 163 est relié électriquement à un nœud ou un rail de fourniture d'un potentiel électrique VRT. Il est relié électriquement à la région photosensible 120 par l'intermédiaire du transistor d'initialisation 50. Dans le premier mode de réalisation, le transistor d'initialisation 50 est un transistor de type double grille, dont les grilles sont les première et deuxième grilles verticales 111, 112.

La première grille verticale 111 est reliée électriquement à un nœud ou un rail de fourniture d'un premier signal électrique TGZ1. La deuxième grille verticale 112 est reliée électriquement à un noeud ou un rail de fourniture d'un deuxième signal électrique TGZ2. Les premier et deuxième signaux électriques TGZ1, TGZ2 sont des potentiels électriques variables dans le temps.

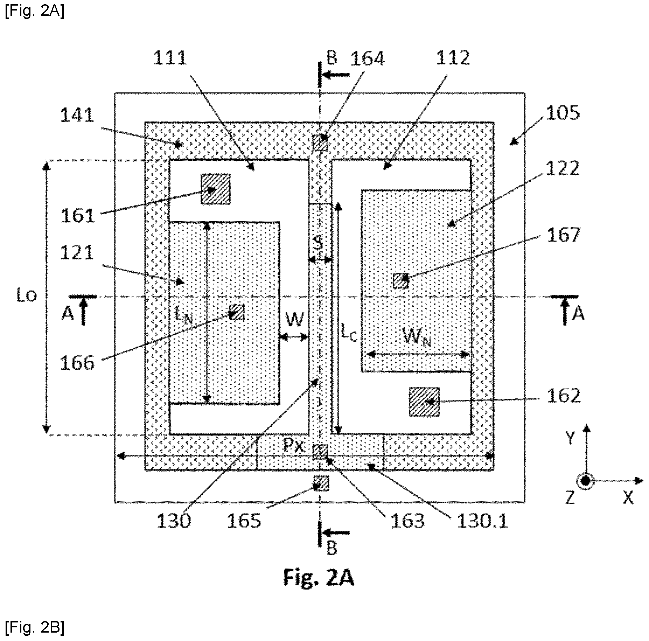

Une variante du premier mode de réalisation va à présent être décrite, en lien avec les figures 2A, 2B et 2C. La figure 2A est une vue schématique de dessus. Sur la figure 2A, on a représenté le plan de coupe A-A de la figure 2B, et le plan de coupe B-B de la figure 2C. Les figures 2B et 2C représentent des cartographies de la concentration en éléments dopants dans ces plans de coupe, obtenues par simulation. Seules les différences avec le premier mode de réalisation sont décrites ci-après.

Dans cette variante, le pixel comporte en outre une zone de contact périphérique 130.1 sur laquelle repose le contact d'initialisation 163. La zone de contact périphérique 130.1 est en contact physique et électrique avec la zone de collecte 130. Elle est par exemple formée d'un seul tenant avec la zone de collecte 130. Elle est dopée du même type de conductivité que la zone de collecte 130, ici de type N. Elle s'étend en profondeur dans le substrat 100 depuis la face supérieure 100.1. Dans cet exemple, elle s'étend horizontalement depuis la zone de collecte 130 et depuis les première et deuxième grilles verticales 111, 112, jusqu'à atteindre la tranchée d'isolation périphérique 105. Elle a par exemple une hauteur le long de l'axe Z, inférieure ou égale à la hauteur de la zone de collecte 130, sans que cela soit indispensable.

La zone de contact périphérique 130.1 a des dimensions et une concentration en éléments dopants ajustés de façon à ne pas créer de barrière ou de puit de potentiel entre la zone de collecte 130 et le contact d'initialisation 163 lorsque le capteur est en fonctionnement. Lorsque la zone de contact périphérique 130.1 et la zone de collecte 130 sont d'égales hauteurs, elles peuvent être réalisées par la même succession d'étapes de procédé. Elles présentent alors des profils de dopage le long de l'axe Z sensiblement identiques, comme cela est le cas sur la figure 2C.

En vue de dessus, le contact d'initialisation 163 est déporté dans une région périphérique du pixel permettant de rapprocher les première et deuxième grilles verticales 111, 112 sans enfreindre une règle de conception de la technologie utiliser pour réaliser le capteur, tel qu'une règle d'espacement minimal entre un contact et une grille verticale. La distance S peut ainsi être réduite par rapport au premier mode de réalisation. Elle est ici égale à 70 nm. Le rapprochement des première et deuxième grilles verticales 111, 112 permet de privilégier le transfert de charges photo-générées depuis la région photosensible 120 vers les premier et deuxième noeuds de détection 121, 122 par rapport au transfert vers la zone de collecte 130.

Dans cette variante, le contour du caisson P 141 épouse celui de la tranchée d'isolation périphérique 105 en vue de dessus, à l'exception d'une région du pixel à l'intérieure de laquelle la zone de contact périphérique 130.1 est en contact avec la tranchée d'isolation périphérique 105.

La figure 3B représente un chronogramme illustrant un fonctionnement possible du circuit de lecture du premier mode de réalisation ou de la variante du premier mode de réalisation. Il est supposé ici que la pluralité de pixels est agencée en une matrice.

Lorsqu'une scène est éclairée par une source de lumière périodique en amplitude de période P_{S}, le chronogramme conduit à une intégration par chaque nœud de détection 121, 122 de parties respectives et distinctes du signal lumineux réfléchi par la scène. Chaque nœud de détection 121, 122 intègre le signal lumineux réfléchi sur des intervalles de temps périodiques de période égale à la période P_{S} et de durée égale à P_{S}/4. Les intervalles de temps du deuxième nœud de détection 122 sont espacés des intervalles de temps du premier nœud de détection 121 d'une durée égale à P_{S}/4.

Le chronogramme comporte une phase d'échantillonnage T2 immédiatement suivie d'une phase de lecture de la matrice T3. La phase d'échantillonnage T2 est précédée d'une phase d'initialisation T1. Le cumul des phases consécutives T1 à T3 constitue une phase d'acquisition d'une image en profondeur, ou d'acquisition d'une trame, par exemple si le capteur est apte à capturer plusieurs images successives. Le cas échéant, la phase de lecture de la matrice T3 d'une trame peut être immédiatement suivie de la phase d'initialisation T1 de la trame suivante, comme cela est représenté ici. La phase de lecture de la matrice T3 comporte une phase de lecture de la ligne T3.1 de la matrice à laquelle le pixel appartient.

Afin de déterminer une information de profondeur à partir du signal lumineux périodique reçu par le capteur, le pixel peut être associé à un autre pixel identique pour lequel le chronogramme a sa phase d'échantillonnage T2 décalée d'un quart de la période P_{S}, modulo la période P_{S}. Alternativement, les phases d'échantillonnage T2 de deux trames successives peuvent être décalées d'un quart de la période P_{S} modulo la période P_{S}, et l'information de profondeur est déterminée à partir des échantillons collectés par le pixel au cours des phases d'acquisition des deux trames successives.

Pendant la phase d'échantillonnage T2, on procède aux transferts des charges photo-générées dans la région photosensible 120, alternativement vers les premier et deuxième nœuds de détection 121, 122. Pour cela, les premier et deuxième transistors de transfert 51.1, 51.2 sont mis alternativement à l'état passant sur des intervalles de temps périodiques de période égale à la période P_{S}, chaque intervalle de temps étant égal à P_{S}/4. Au cours de la phase d'échantillonnage T2, le premier signal électrique TGZ1 et le deuxième signal électrique TGZ2 commutent en opposition de phase, entre une première valeur V₁ et une deuxième valeur V₂, en passant par une troisième valeur V₃ pendant une durée égale à P_{S}/4.

Lorsque les potentiels électriques appliqués aux première et deuxième grilles verticales 111, 112 sont respectivement égaux à V₁ et à V₂, le deuxième transistor de transfert 51.2 est dans un état passant, tandis que le premier transistor de transfert 51.1 et le transistor d'initialisation 50 sont dans des états bloqués. Inversement, lorsque les potentiels électriques appliqués aux première et deuxième grilles verticales 111, 112 sont respectivement égaux à V₂ et à V₁, le premier transistor de transfert 51.1 est dans un état passant, tandis que le deuxième transistor de transfert 51.2 et le transistor d'initialisation 50 sont dans des états bloqués

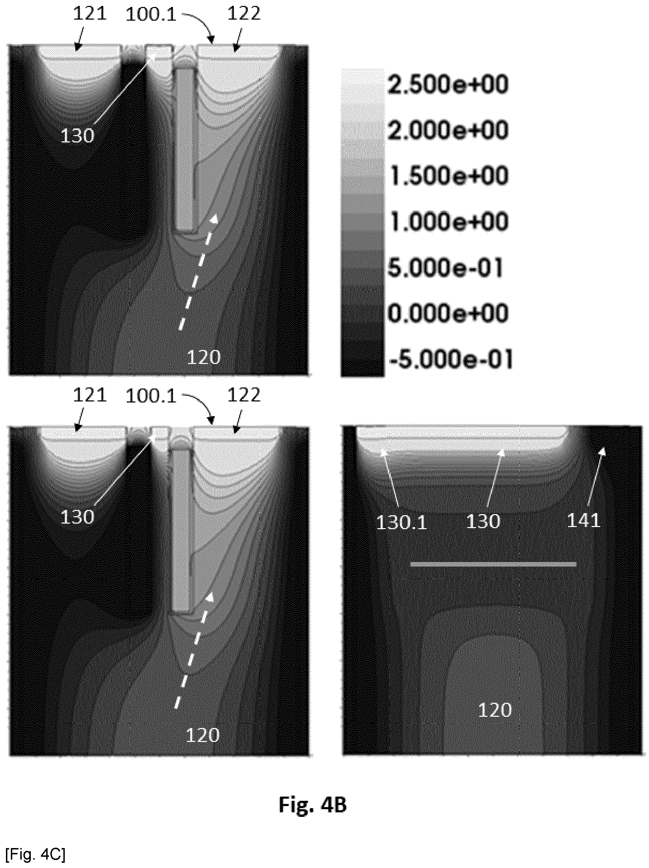

Dans cet exemple pour lequel les charges transférées sont des électrons, V₁ est égal à -0,8 V et V₂ est égal à 1,8 V. Dans ces conditions, une cartographie du potentiel électrique simulé est donnée en figure 4B. La figure 4B représente un instant de la phase d'échantillonnage T2 pour lequel le deuxième transistor de transfert 51.2 est dans un état passant, tandis que le premier transistor de transfert 51.1 et le transistor d'initialisation 50 sont dans des états bloqués.

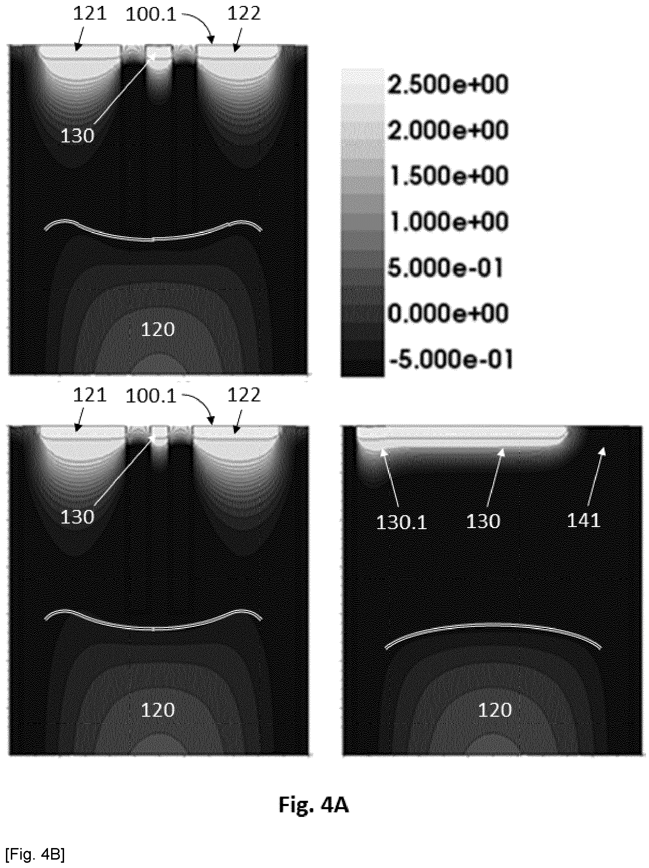

En haut à gauche des figures 4A à 4C, on donne une cartographie du potentiel électrique du premier mode de réalisation, dans le plan de coupe A-A de la figure 1A. En bas à gauche des figures 4A à 4C, on donne une cartographie du potentiel électrique de la variante du premier mode de réalisation, dans le plan de coupe A-A de la figure 2A. En bas à droite des figures 4A à 4C, on donne une cartographie du potentiel électrique de la variante du premier mode de réalisation, dans le plan de coupe B-B de la figure 2A. Les trois cartographies d'une même figure sont obtenues pour un même état de polarisation électrique du pixel. En haut à droite, on donne l'équivalence en Volt des niveaux de gris utilisés sur les cartographies. Sur ces figures, on a représenté les positions approximatives de certaines barrières de potentiel par des lignes doubles. On a également représenté par une flèche en pointillés, une direction générale de chaque transfert prioritaire de charges photo-générées dans la région photosensible 120.

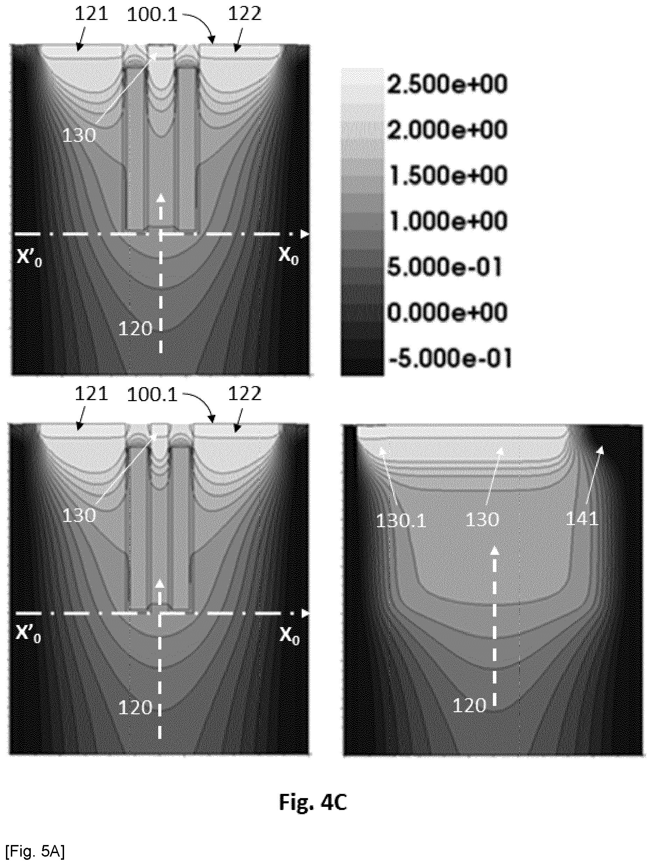

La figure 4C représente un instant de la phase de lecture de la matrice T3 ou un instant d'une phase d'initialisation de la région photosensible 120 similaire à la phase d'initialisation T1 pour laquelle les première et deuxième grilles verticales 111, 112 sont polarisées à un potentiel électrique plus faible. La figure 4A représente un état de polarisation du pixel pouvant servir dans un chronogramme alternatif possible.

Les résultats de simulation des figures 4A à 4C sont obtenus en fixant VRT à 1,8 V, V_{RST} à 1,8 V, V_{CDTI} à -0,8 V et V_{P} à -0,5 V. Pour ces simulations, les premier et deuxième contacts 166, 167 sont à un potentiel électrique de 1,8 V, qui est leur potentiel électrique d'initialisation, c'est-à-dire avant d'avoir collecté des charges électriques. Le potentiel électrique du contact d'initialisation 163 est égal à 1,8 V.

En figure 4B, le gradient du potentiel électrique atteint un maximum en valeur absolue dans une direction (flèche blanche en pointillées) reliant la région photosensible 120 au deuxième nœud de détection 122, de sorte que 99 % des charges transférées depuis la région photosensible 120 atteignent le deuxième nœud de détection 122. Ainsi, le deuxième canal est passant indépendamment du premier canal et du canal de collecte.

Pendant la phase de lecture de la matrice T3, les première et deuxième grilles verticales 111, 112 sont simultanément polarisées à une tension de polarisation électrique supérieure ou égale à une tension de seuil des premier et deuxième transistors de transfert 51.1, 51.2. Cependant l'arrangement particulier des première et deuxième grilles verticales 111, 112, l'une par rapport à l'autre, maintient les premier et deuxième transistors de transfert 51.1, 51.2 dans un état bloqué.

Au cours de cette phase, les première et deuxième grilles verticales 111, 112 sont maintenues à un potentiel électrique égal à une valeur intermédiaire Vᵢ, permettant de prévenir un transfert de charges depuis la région photosensible 120 vers un nœud de détection 121,122. De préférence, les première et deuxième grilles verticales 111, 112 sont maintenues au potentiel électrique Vᵢ tout du long de la phase de lecture de la matrice T3, comme représenté ici. Le potentiel électrique Vᵢ rend passant le transistor d'initialisation 50.

Selon une première possibilité, l'application du potentiel électrique Vᵢ abaisse une barrière de potentiel située entre la zone de collecte 130 et la région photosensible 120 de façon à ce qu'elle soit inférieure à des barrières de potentiel situées entre d'une part la région photosensible 120, et d'autre part, les premier et deuxième nœuds de détection 121, 122.

Selon une deuxième possibilité obtenue en figure 4C, le potentiel électrique Vᵢ appliqué aux première et deuxième grilles verticales 111, 112 est suffisant pour créer un champ électrique tendant à faire converger prioritairement les charges photo-générées vers le canal de collecte. Le gradient de potentiel électrique étant maximal dans la direction de la zone de collecte 130, une différence de potentiel électrique δV existe entre une face de chaque grille verticale 111, 112 en regard d'un nœud de détection 121, 122 et une face opposée de la même grille verticale en regard de la zone de collecte 130.

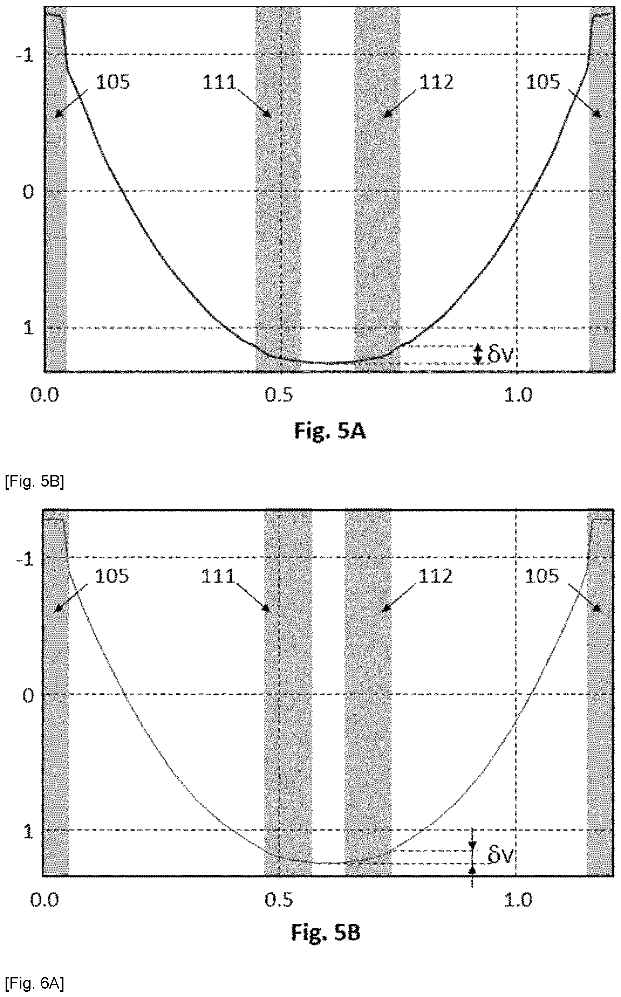

Sur les figures 5A et 5B, on a représenté la valeur du potentiel électrique de la figure 4C, le long de segments horizontaux [X'o, Xo] intersectant un axe central du pixel et une face inférieure de chaque grille verticale 111,112 (matérialisés par des lignes mixtes sur la figure 4C). Sur ces figures, le potentiel électrique est donné en Volt sur l'axe des ordonnées. En abscisses, on a la position dans le pixel le long de [X'o, Xo], donnée en µm. En gris, on a matérialisé les positions de la tranchée d'isolation périphérique 105 et des première et deuxième grilles verticales 111, 112. La figure 5A correspond au premier mode de réalisation, la figure 5B à la variante du premier mode de réalisation. La différence de potentiel δV est repérée sur ces figures. Elle est égale à 126 mV pour la figure 5A et à 111 mV pour la figure 5B. Ces valeurs sont suffisantes pour qu'au moins 97 % des charges transférées depuis la région photosensible 120 atteignent la zone de collecte 130.

Ainsi, au cours de la phase de lecture de la matrice T3, le transistor d'initialisation 50 a une fonction d'anti-éblouissement (ou « anti-blooming », en anglais) pour les premier et deuxième nœuds de détection 121, 122, et la lecture des potentiels électriques des premier et deuxième nœuds de détection 121, 122 n'est pas faussée au cours de la phase de lecture de la matrice T3.

La valeur intermédiaire Vᵢ est par exemple supérieure ou égale à V₂. Dans cet exemple, Vᵢ est égal à V₂.

A un instant de la phase de lecture de la matrice T3, la phase de lecture de la ligne T3.1 commence lorsque le transistor de sélection 54 est mis à un état passant (RD a une valeur haute). Une première lecture des premier et deuxième nœuds de détection 121, 122 est effectuée à un instant t_{S} de la phase de lecture de la ligne T3.1 correspondant à une collecte d'échantillons. Ultérieurement, un pulse en tension est appliqué à la grille des transistors de précharge 52 pour initialiser les premier et deuxième nœuds de détection 121, 122 à un potentiel électrique V_{ech1}, V_{ech2} sensiblement égal à VRST. Ensuite, une lecture d'un potentiel de référence de chaque nœud de détection 121, 122 est lue à un instant t_{R} de la phase de lecture de la ligne T3.1.

Pendant la phase d'initialisation T1, les première et deuxième grilles verticales 111, 112 sont simultanément polarisées à un potentiel électrique égal à la troisième valeur V₃, supérieure ou égale à V₂ et à Vᵢ. Au cours de cette phase, le canal de collecte est passant indépendamment du premier canal et du deuxième canal. La région photosensible 120 est par conséquent vidée des charges électriques qu'elle contient. La région photosensible 120 est ainsi initialisée, ou remise à zéro. Sur le chronogramme, V₃ est strictement supérieur à V₂ et égal à 2,5 V. De la même façon, la région photosensible 120 est initialisée pendant la phase d'échantillonnage T2 entre chaque commutation des premier et deuxième signaux électriques TGZ1, TGZ2.

En figure 4A, on a représenté une situation pour laquelle TGZ1 et TGZ2 sont égaux à -0,8 V, permettant de créer une barrière de potentiel entre d'un côté la région photosensible 120 et de l'autre les premier et deuxième noeuds de détection 121, 122 et la zone de collecte 130. Dans ce cas de figure, aucune charges photo-générées dans la région photosensible 120 n'est transférée à un noeud de détection 121, 122 ou à la zone de collecte 130.

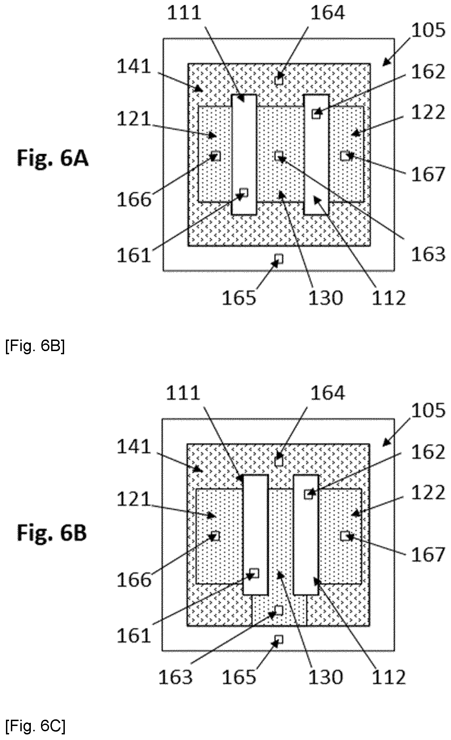

A présent, d'autres modes de réalisation de l'invention sont décrits. Seules les différences avec le premier mode de réalisation sont explicitées. Pour certains modes de réalisation, les première et deuxième grilles verticales 111, 112 peuvent avoir d'autres formes en vue de dessus, comme par exemple une forme en I avec ou sans empattement au sommet et/ou à la base du I. En figures 6A à 6C, on a représenté des exemples de pixel comportant des première et deuxième grilles verticales 111, 112 en forme de barre en vue de dessus (« I » sans empattement).

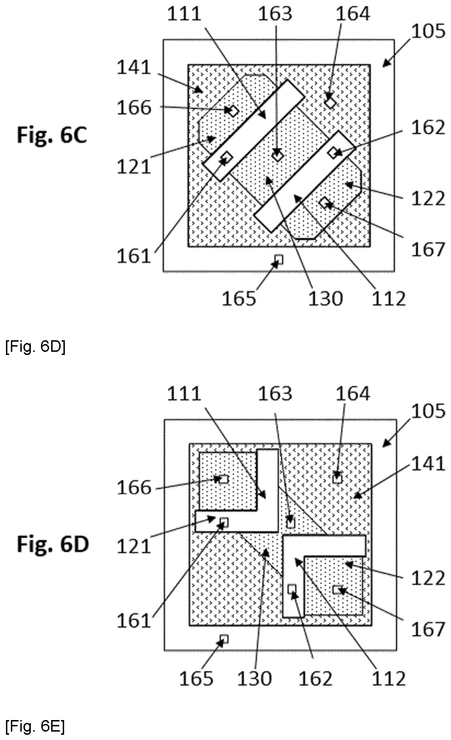

En figure 6A, le contact d'initialisation 163 est positionné au centre du pixel, similairement au premier mode de réalisation. En figure 6B, le contact d'initialisation 163 est positionné en périphérie du pixel, similairement à la variante du premier mode de réalisation. La figure 6C représente une situation similaire à celle de la figure 6A, pour laquelle on a fait pivoter les première et deuxième grilles verticales 111, 112 de 45° autour d'un axe parallèle à l'axe Z passant par le centre du pixel.

Les première et deuxième grilles verticales 111, 112 peuvent qu'une seule branche parmi les première et deuxième branches. Elles ont alors une forme générale en L, en vue de dessus. Un tel exemple est illustré en figure 6D. Dans celui-ci, les portions principales des première et deuxième grilles verticales 111, 112 ne sont pas en vis-à-vis l'une de l'autre, mais il peut être avantageux qu'elles le soient. Le contact d'initialisation 163 peut occuper une position quelconque du pixel, déportée ou non. Les première et deuxième grilles verticales 111, 112 peuvent faire un angle quelconque avec les axes X ou Y dans un plan parallèle au plan (X, Y).

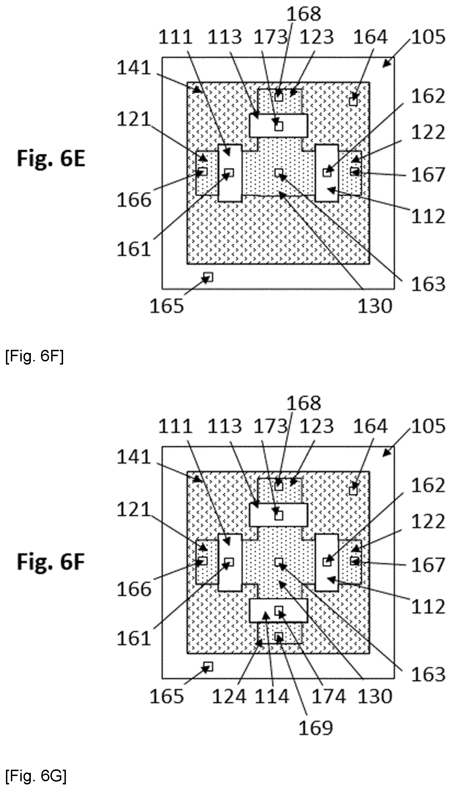

Selon un apport de l'invention, la surface du pixel dédiée à l'initialisation de la région photosensible 120 est réduite par rapport aux modes de réalisation de l'art antérieur. Cet avantage peut être mis à profit pour accroître le nombre de grilles de transfert par pixel, sans augmenter la taille du pixel Px. Ainsi, il est possible d'augmenter le nombre d'échantillons collectés par pixel. Les figures 6E à 6G illustrent des modes de réalisation de l'invention présentant un nombre de transistors de transfert strictement supérieur à 2, chacun comportant une grille de transfert vertical distinct, un canal distinct commandable par la grille verticale et un nœud de détection distinct. Tous les nœuds de détection et la zone de collecte 130 sont dopés du même type de conductivité.

Dans ces modes de réalisation, le transistor d'initialisation 50 a autant de grilles qu'il y a de grilles de transfert dans le pixel. Chaque grille du transistor d'initialisation 50 est une grille de transfert du pixel permettant de collecter un échantillon. En fonctionnement, les charges transférées depuis la région photosensible 120 transitent prioritairement vers la zone de collecte 130 lorsque toutes les grilles de transfert sont polarisées au potentiel V₃. Lorsque toutes les grilles de transfert sont polarisées au potentiel Vᵢ, le transistor d'initialisation 50 assure une fonction d'anti-éblouissement lors d'une phase de lecture de la matrice T3. Le circuit de lecture est configuré pour appliquer un signal électrique par grille de transfert de sorte à rendre alternativement passant un unique canal parmi tous les canaux associés à une grille de transfert et le canal de collecte 130 et à transférer prioritairement des charges électriques photo-générées par ce canal.

En figure 6E, on a illustré un mode de réalisation présentant trois grilles de transfert permettant de collecter trois échantillons. Celui présente une configuration similaire à celle de la figure 6A, pour laquelle une troisième grille verticale 113 en forme de barre et un troisième nœud de détection 123 ont été ajoutés. La troisième grille verticale 113 est identique aux première et deuxième grilles verticales 111, 112. Le troisième nœud de détection 123 est identique aux premier et deuxième nœuds de détection 121, 122.

En vue de dessus, les première, deuxième et troisième grilles verticales 111, 112, 113 sont centrées sur 3 côtés consécutifs d'un carré fictif, lui-même centré sur le pixel. Le circuit de lecture comporte en outre un troisième contact de grille 173 en contact physique avec l'électrode de grille 115 de la troisième grille verticale 113, et un troisième contact 168 en contact physique avec le troisième nœud de détection 123.

Dans un mode de réalisation alternatif, les trois grilles verticales peuvent ensemble, être tournées de 45°. Le contact d'initialisation 163 peut être déporté en périphérie du pixel.

En figure 6F, on a représenté un mode de réalisation présentant quatre grilles de transfert verticales permettant de collecter quatre échantillons. Celui présente une configuration similaire à celle de la figure 6E, pour laquelle une quatrième grille verticale 114 en forme de barre et un quatrième nœud de détection 124 ont été ajoutés. La quatrième grille verticale 114 est identique aux autres grilles verticales. Le quatrième nœud de détection 124 est identique aux autres nœuds de détection.

En vue de dessus, les quatre grilles verticales sont centrées sur quatre côtés d'un carré fictif centré sur le pixel. Le circuit de lecture comporte en outre un quatrième contact de grille 174 en contact physique avec l'électrode de grille 115 de la quatrième grille verticale 114, et un quatrième contact 169 en contact physique avec le quatrième nœud de détection 124.

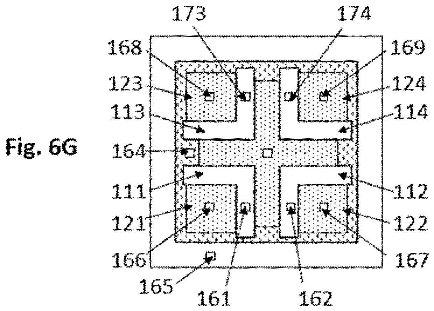

La figure 6G représente un autre mode de réalisation comportant quatre grilles de transfert verticales. Dans celui-ci, les grilles verticales ont chacune une forme en L en vue de dessus.

Des modes de réalisation particuliers viennent d'être décrits. Différentes variantes et modifications apparaîtront à l'homme du métier.

## Revendications

1. Capteur d'une image en profondeur comprenant un circuit de lecture et une pluralité de pixels formés dans et sur un substrat (100) du capteur, chaque pixel comportant :
o une région photosensible (120) formée dans le substrat (100) et configurée pour convertir des photons en charges électriques,
o un premier nœud de détection (121), un deuxième nœud de détection (122) et une zone de collecte (130) situés à l'aplomb de la région photosensible (120) et dopés d'un premier type de conductivité,
o un premier transistor de transfert (51.1) comprenant une première grille verticale (111) et un premier canal commandable par la première grille verticale (111),
o un deuxième transistor de transfert (51.2) comprenant une deuxième grille verticale (112) et un deuxième canal commandable par la deuxième grille verticale (112),
o un transistor d'initialisation (50) de la région photosensible à grilles multiples, comprenant les première et deuxième grilles verticales (111, 112) et un canal de collecte commandable par les première et deuxième grilles verticales (111, 112),
le pixel étant tel que le premier canal, le deuxième canal et le canal de collecte s'étendent dans le substrat (100) entre la région photosensible (120) et, respectivement, le premier nœud de détection (121), le deuxième nœud de détection (122) et la zone de collecte (130) ; le circuit de lecture étant configuré pour appliquer un premier signal électrique (TGZ1) à la première grille verticale (111) et un deuxième signal électrique (TGZ2) à la deuxième grille verticale (112) de sorte à rendre alternativement passant chacun du premier canal, du deuxième canal et du canal de collecte, indépendamment des deux autres canaux.

2. Capteur selon la revendication 1, dans lequel la zone de collecte (130) s'étend verticalement dans le substrat (100) plus profondément que les premier et deuxième nœuds de détection (121, 122).

3. Capteur selon la revendication 1 ou 2, dans lequel chaque pixel comprend en outre une tranchée d'isolation périphérique (105) s'étendant verticalement dans le substrat (100) depuis une face supérieure (100.1) du substrat (100) et délimitant latéralement la région photosensible (120).

4. Capteur selon la revendication 3 comprenant en outre un caisson (141) dopé d'un deuxième type de conductivité opposé au premier type de conductivité, dans lequel le caisson (141) est en contact avec la tranchée d'isolation périphérique (105) et affleure la face supérieure (100.1) du substrat (100).

5. Capteur selon la revendication 4, dans lequel la tranchée d'isolation périphérique (105) comprend une électrode verticale (106) en un matériau semiconducteur dopé du deuxième type de conductivité.

6. Capteur selon l'une quelconque des revendications précédentes, dans lequel les première et deuxième grilles verticales (111, 112) comportent des portions principales respectives en vis-à-vis, symétriques l'une de l'autre par rapport à un axe de symétrie vertical passant par le centre du pixel et dans lequel la zone de collecte (130) s'étend d'une portion principale à l'autre.

7. Capteur selon la revendication 6 dans lequel les première et deuxième grilles verticales (111, 112) ont chacune une forme de U en vue de dessus, et dans lequel le premier noeud de détection (121) et le deuxième noeud de détection (122) s'étendent chacun entre deux branches opposées du U formé par, respectivement, la première grille verticale (111) et la deuxième grille verticale (112).

8. Capteur selon la revendication 6 ou 7, dans lequel le circuit de lecture comporte un contact d'initialisation (163) et le pixel comprend en outre une zone de contact périphérique (130.1) du premier type de conductivité, prolongeant la zone de collecte (130) dans une région périphérique du pixel sur laquelle repose le contact d'initialisation (163).

9. Capteur selon l'une quelconque des revendications précédentes, dans lequel le circuit de lecture est configuré pour commuter en opposition de phase, le premier signal électrique (TGZ1) et le deuxième signal électrique (TGZ2) entre une première valeur et une deuxième valeur de manière à rendre alternativement passant le premier canal et le deuxième canal lors d'une phase d'échantillonnage (T2), tout en maintenant bloqué le canal de collecte.

10. Capteur selon la revendication 9, dans lequel le circuit de lecture est configuré pour affecter une troisième valeur au premier signal électrique (TGZ1) et au deuxième signal électrique (TGZ2) de manière à rendre passant le canal de collecte pendant une phase d'initialisation (T1) de la région photosensible (120) précédant la phase d'échantillonnage (T2).

11. Capteur selon la revendication 10, dans lequel la pluralité de pixels est agencée en matrice, et dans lequel le circuit de lecture est configuré pour affecter un potentiel électrique égal à une valeur intermédiaire aux première et deuxième grilles verticales (111, 112) de manière à empêcher un transfert de charges électriques photo-générées dans la région photosensible (120) vers les premier et deuxième noeuds de détection (121, 122) pendant une phase de lecture de la matrice (T3), la valeur intermédiaire étant différente de la troisième valeur.
